# EUROPEAN PATENT SPECIFICATION

(11) **EP 0 095 674 B1**
(45) Date of publication and mention of the grant of the patent: **01.09.1993**
(21) Application number: 83104982.0
(22) Date of filing: 19.05.1983
(51) Int. Cl.: H03M 1/00

(54) **Apparatus for converting data between analog and digital values**
Gerät zur Umwandlung zwischen analogen und digitalen Werten
Appareil de conversion entre valeurs analogiques et numériques

(30) Priority: 01.06.1982 US 383544
(43) Date of publication of application: 07.12.1983
(73) Proprietor: BROOKTREE CORPORATION, Del Mar California 92014 (US)
(72) Inventor: Katzenstein, Henry S., Pacific Palisades California 90272 (US)
(74) Representative: Baillie, Iain Cameron

(56) References cited:
- EP-A- 0 043 897
- GB-A- 952 720
- GB-A- 2 069 265
- INTERNATIONAL SOLID-STATE CIRCUITS CONFERENCE, vol. 22, 15th February 1979, pages 178,179,292,293, IEEE, New York, US; J.A. SCHOEFF: "An inherently monotonic 12b DAC"

## Description

### TECHNICAL FIELD

This invention relates to apparatus for converting data between a digital form and an analog form. More particularly, the invention relates to apparatus which provides such conversion instantaneously and on a monotonic basis and in a simple and reliable manner.

### BACKGROUND OF THE INVENTION

Various types of equipment receive information in analog form. Such equipment includes process control equipment measuring instruments, communication equipment and a wide variety of other equipment. Digital computers and data processing systems often receive input parameters in analog form from such equipment and convert these parameters to digital form for processing in the computer or the data processing equipment. After the analog information has been converted to digital information and has been processed, the output information from the digital computer or the data processing equipment is often converted to analog form. By converting the digital information to analog form, the user can assimilate the information in ways which would be difficult if the information remained in digital form.

A good example of the conversions discussed in the previous paragraph is in the recording and reproduction of music. The music is produced in analog form. It is converted to digital form by recently developed data processing techniques and is recorded on a medium such as a tape or a disc. When the music is to be reproduced, it is converted again to analog form because this is the form which is necessary operate sound transducers to give meaning to the listener when he hears the music.

As digital computers and data processing equipment have become widespread throughout industry and the office and have even become common in the home, the need for inexpensive, simple and reliable apparatus for converting information between analog and digital forms has become of increasing concern. A considerable effort has been devoted over a period of several decades to provide for converting apparatus which is simple, inexpensive and reliable. In spite of such efforts, the converting apparatus now in use does not meet such criteria.

The converting apparatus now in use also has other problems of long-standing. For example, the converting apparatus now in use may not be monotonic unless it is quite expensive and comply. By "monotonic" is meant that digital information of progressively increasing value is converted to analog information of progressively increasing value without any decrease in the analog value as the digital value progressively increases. The converting apparatus now in use also has relatively high differential and integral non-linearities unless the apparatus is quite expensive and comply. Integral non-linearities result from errors produced in a conversion between analog and digital values over a wide range of such values. Differential non-linearities result from errors produced in a conversion between analog and digital values over a relatively narrow range of such values.

The converting apparatus now in general use also has a problem of major proportions. This results when particular digital values are increased incrementally by a single digit. For example, problems in the converters now in use result when a binary representation of "511" is converted to a binary representation of "512". This results from the fact that the binary representation of "511" is represented by a value of 0111111111 and a binary representation of "512" is represented by 1000000000 where the least significant digit is at the right. As will be seen, the values of each binary digit changes when the decimal value changes from "511 " to "512". As the binary values change from 0111111111 to 1000000000, discontinuties may occur because there is a change between a binary value of "0" and a binary value of "1" " at each digital position. These discontinuities may prevent the converter from being truly monotonic. This problem even exists in converters which are made quite complex in an attempt to overcome the problem.

A prior art digital to analog converter which purports to be transient free is disclosed in U.K. patent application GB 2,069,265A. The technique disclosed in that published application utilizes a complex arrangement of gates which are responsive not only to the binary signal to be converted, but also to the output of other gates in the arrangement, which causes the time for the arrangement of gates to come to the correct logic condition to be relatively slow compared to the switching time of an individual gate. As a result, the converter shown in the U.K. patent application tends to operate slowly, indeed, too slowly to provide a commercially viable converter.

### BRIEF DESCRIPTION OF THE INVENTION

This invention as defined in claim 1 provides a converter which is able to operate with a high precision at high levels of power. As a result, the converting apparatus is capable of being used in areas not available for the converters of the prior art. For example, such apparatus is able to convert the digital information to the oral information in analog form by serving both as a converter and an amplifier. The converter of this invention also has other advantages of some importance. For example, the converter is able to provide an instantaneous conversion between analog and digital values, and it provides a monotonic operation with minimal integral and differential non-linearities. The converter is also quite simple in construction and is reliable in operation.

In one embodiment of the invention, apparatus is provided for converting between analog and digital values. Pluralities of control switches are also provided, the number of control switches in each plurality being directly related to the digital significance of the control switches in such plurality. The control switches may be paired to provide for a conductivity of one switch in each pair. The signals representing individual digital values are introduced to the pluralities of control switches of corresponding digital significance to provide for the conductivity of an individual one of the control switches in each pair in accordance with the digital value represented by the signals introduced to the control switches in such pair.

The switches are connected in a repetitive array and to output members, and to a line to provide paths through the conductive ones of the control switches. Since the output members are conductive, the control switches operate to introduce the current through the output members to the line. This provides for progressive increases in the number of the output members connected to the line with progressive increases in the digital value and for a connection to the line of the output members previously connected to the line with progressive increases in the digital value. The cumulative current through the output members connected to the line is indicative of the analog value.

Additional means may be connected to provide an indication of the digital values of reduced digital significance relative to the digital significance of the pluralities of control switches. An interpolation line may be connected to the repetitive array to receive a current from the output member to be connected next to the line for increasing digital values. The interpolation line and the additional means and the means providing the digital values of reduced digital significance may be connected to provide a current from the additional means in accordance with the value of the digits of reduced digital significance and for introducing such current to the line to provide an output current on the line in representation of the analog value. The additional means may constitute another repetitive array.

### IN THE DRAWINGS

FIGURE 1 is a schematic circuit diagram of one embodiment of the invention, this embodiment employing magnetic relays and switches as control elements;
FIGURE 2 is a truth table illustrating the operation of the system shown in FIGURE 1;
FIGURE 3 is a schematic circuit diagram of another embodiment of the invention, this embodiment employing transistors as control elements;
FIGURE 4 is a block diagram of another embodiment of the invention, this embodiment illustrating the interconnection of more than one of the embodiments shown in FIG. 3;
FIGURE 5 is a schematic circuit diagram of a current generator capable of being used in the embodiment of FIG. 4;
FIGURE 6 is a schematic circuit diagram of another current generator capable of being used in the embodiment of FIGURE 4;
FIGURE 7 is a simplified circuit diagram illustrating another transistor arrangement which can be used in the embodiment of FIGURE 3;
FIGURE 8 is a schematic diagram of an integrated circuit chip on which the converter shown in FIGURE 3 may be disposed;
FIGURE 9 is a schematic diagram of an integrated circuit chip on which a plurality of converters such as shown in FIGURE 3 may be disposed in modular form;
FIGURE 10 is a schematic diagram showing the spaced disposition on an integrated circuit chip of different transistors shown in FIGURE 3;
FIGURE 11 is a block diagram of apparatus included in the converter of FIGURE 3 to regulate the output from the converter; and
FIGURE 12 is a block diagram showing an analog-to-digital converter which incorporates the apparatus of FIGURE 3.

### DETAILED DESCRIPTION OF THE INVENTION

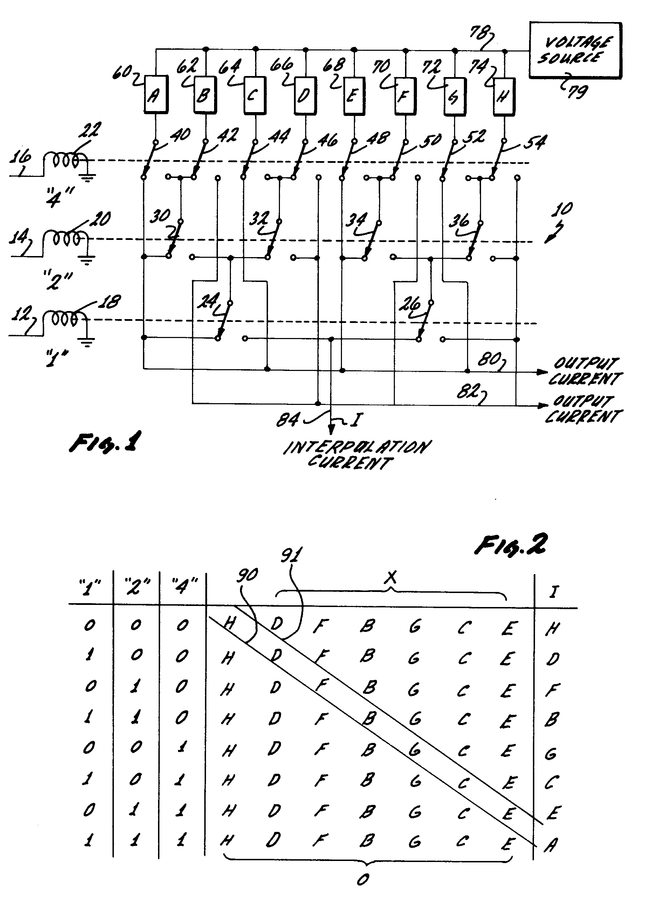

In the embodiment of the invention shown in FIGURE 1, a digital-to-analog converter generally indicated at 10 is provided. The converter 10 receives digital signals on a plurality of input lines 12, 14 and 16. The signals on the lines preferably represent information in binary form. For example, the signals on the line 12 may represent a binary value of "1" and the signal on the lines 14 and 16 may respectively represent binary values of "2¹" and 2²". Illustratively, a binary "1" may be represented by a signal of high amplitude and a binary "0" may be represented by a signal of low amplitude. Although only three (3) digits are shown, it will be appreciated that any particular number of digits may be used.

Actuating means such as solenoids may be associated with each of the lines 12, 14 and 16. The solenoids respectively associated with the lines 12, 14 and 16 are designated as 18, 20 and 22. Control switches 24 and 26 are respectively associated with the solenoid 18. Control switches 30, 32, 34 and 36 are respectively associated with the solenoid 20 and control switches 40, 42, 44, 46, 48, 50 and 52 are associated with the solenoid 22. Each of the control switches is provided with a movable arm which is moved from the left stationary contact to the right stationary contact In FIGURE 1 when the associated solenoid is energized.

As will be appreciated, the solenoids 18, 20 and 22 and the switches 24 through 54 (even numbers only) may be considered to be representative of different types of arrangements which can be used. The switches may be electromagnetic as shown in FIGURE 1 or may constitute any other type of arrangement for providing one state of operation when the digit controlling the operation of the switch has a binary value of "1" and for providing another state of operation when the digit controlling the operation of the switch has a binary value of "0". As will be seen, for example, from the embodiment shown in FIG 3, the switches may be replaced by pairs of transistors.

A plurality of output members 60, 62, 64, 66, 68, 70, 72 and 74 are also provided in the embodiment of FIGURE 1. Each of the output members is constructed to provide an output having the same characteristics as the output provided by the other members. For example, the output members 60 through 74 (even numbers only) may constitute current sources which provide substantially equal currents when energized.

The control switches 24 through 54 (even numbers only) are connected in a repetitive array. This array has a repetitive pattern of switch connections to obtain the operation of the switches in a pattern dependent upon the binary coded input signals on lines 12, 14 and 16. The movable arms of the control switches 40 through 54 (even numbers only) are respectively connected to the output members 60 through 74 (even numbers only), each of which receives an input voltage on a line 78 from a source 79.

The left stationary contacts of the switches 40, 44, 48 and 52 are connected to an output line 80 and the right stationary contacts of the switches 42, 46 50 and 54 are connected to an output line 82. Connections are made from the right contact of the switch 40 and the left contact of the switch 42 to the movable arm of the switch 30, from the right contact of the switch 44 and the left contact of the switch 46 to the movable arm of the switch 32, from the right contact of the switch 48 and the left contact of the switch 50 to the movable arm of the switch 34 and from the right contact of the switch 52 and the left contact of the switch 54 to the movable arm of the switch 36.

The left stationary contacts of the switches 30 and 34 are connected to the output line 80, and the right stationary contacts of the switches 32 and 36 are connected to the output line 82. The right stationary contact of the switch 30 and the left stationary contact of the switch 32 are common with the movable arm of the switch 24 and the right stationary contact of the switch 34 and the left stationary contact of the switch 36 are common with the movable arm of the switch 26. The left stationary contact of the switch 24 is connected to the output line 80 and the right stationary contact of the switch 26 is connected to the output line 82. The right stationary contact of the switch 24 and the left stationary contact of the switch 26 are common with an interpolation line 84.

Figure 2 provides a table indicating the states of operation of the output members 60 through 74 (even numbers only) for different digital values represented by the signals on the lines 12, 14 and 16. As will be seen, the first three columns of Figure 2 respectively represent the binary values of the signals on the lines 12, 14 and 16. These binary values correspond in successive rows to analog values between "0" and "7". For example, in the third row a value of "010" indicates an analog value of "2" and, in the sixth row, a digital representation of "101" represents an analog value of "5".

The next seven (7) columns represent the states of connection of the output members 60 through 74 (even numbers only). These states of conductivity are represented by the letters "A" through "H" which respectively correspond to the output members 60 through 74 (even numbers only). The letters "A" through "H" are shown in Figure 1 within the blocks respectively representing the output members 60 through 74 (even numbers only).

Diagonal lines 90 and 91 are shown in Figure 2. These diagonal lines delineate the conductive ones of the output members connected to the output line 82 for the different values between "0" and "7" and the output members connected to the output line 80 for such values. The indications to the left of the diagonal line 90 represent the output members connected to the output line 82 and the indications to the right of the diagonal line 91 represent the output members connected to the output line 80. The output members between the lines 90 and 91 are connected to the interpolation line 84.

The number of output members to the left of the line 90 for any digital value corresponds to the digital value indicated in the first three columns. For example, for a digital value of "010" corresponding to an analog value of "2", the output members "H" and "D" are connected to the output line 82 so that the output line indicated an analog value of "2". Similarly, for a digital value of "101" corresponding to an analog value of "5", the output members "H", "D", "F", "B" and "G" are connected to the output line 82 so that the line 82 indicates the analog value of "5".

As will be further seen, the output members previously connected to the output line 82 for any digital value continue to remain connected to the output line 82 as the digital value increases. In this way, the output indication of the digital value is monotonic for any value of the count. Furthermore, by maintaining the characteristics of the output members 60 through 74 (even numbers only) substantially constant for the different output members, the circuit shown in Figure 1 has low differential and integral nonlinearities.

The operation of the circuitry shown in Figure 1 may be seen by an analysis of specific digital values. For example, for a digital value of "010" corresponding to an analog value of "2", a digital value of "1" " is produced on the line 14 to actuate the movable arms of the control switches 30, 32, 34 and 36 from the left stationary contacts to the right stationary contacts of the switches. This causes the output member 74 to be conductive through a circuit including the voltage source 79, the line 78, the output member 74, the movable arm and left stationary contact of the switch 54, the movable arm and right stationary contact of the switch 36 and the output line 82. Similarly, a circuit is established to the output line 82 through the output member 66. This circuit includes the voltage source 79, the output member 66, the movable arm and left stationary contact of the switch 46, the movable am and right stationary contact of the switch 32 and the line 82.

The movable arms of the switches 24 and 26 and of the switches 40, 42, 44, 46, 48, 50, 52 and 54 are actuated from the left stationary contacts to the right stationary contacts of the switches when the digital value is "101" representing an analog value of "5". When these switches are actuated, the output member 74 is energized through a circuit including the voltage source 79, the output member 74, the switch 54 and the output line 82; the output member 66 is energized through a circuit including the voltage source 79, the output member 66, the switch 46 and the output line; the output member 70 is energized through a circuit including the voltage source 79, the output member 70, the switch 50 and the output line 82; and the output member 62 is energized through a circuit including the voltage source, the output member, the switch 42 and the output line 82. The output member 72 is energized through a circuit including the output member, the switch 52, the switch 36, the switch 26 and the output line 82.

The last column of Figure 2 indicates the particular one of the output members 60 through 74 (even numbers only) to be connected to the interpolation line 84 for any particular digital value. For example, the F output member is indicated in the last column of Figure 2 as being the particular output member which is connected to the interpolation line 84. As will be seen, this output member then is connected to the output line 82 when the analog value advances from "2" to "3". For an analog value of "2", the output of the F output member is introduced to the interpolation line 84 through a circuit including the voltage source 79, the F output member 70, the movable arm and left stationary contact of the switch 50, the movable arm and right stationary contact of the switch 34, the movable arm and left stationary contact of the switch 26 and the interpolation line 84. In a sense, the connection of individual ones of the switches 70 through 84 (even numbers only) to the interpolation line 84 at different instants indicates the digital value being converted at such instants. The interpolation line 84 also has other important utilities, as will be seen from a subsequent discussion of the embodiment shown in Figure 4.

Figure 3 shows an arrangement substantially similar in concept to that of Figure 1 except that the control switches of Figure 1 are replaced by control transistors in Figure 3. In view of this, Figure 3 is simplified from Figure 1 so that only the operation of the circuit for the digital values 2° = 1 and 21 = is shown. The digital values 2° and 2¹ are respectively provided on lines 112 and 114. The line 112 is connected to the bases of transistors 116, 118, 120 and 122. The transistors 116, 118, 120 and 122 may constiture field effect transistors, particularly MOS field effect transistors, or may constiture any other suitable type of control transistor. The transistors 116 and 120 may particularly comprise N-channel field effect transistors and the transistors 118 and 122 may comprise P-channel field effect transistors.

Similarly, the line 114 is connected to the bases of transistors 130, 132, 134, 136, 138, 140, 142 and 144. As with the transistors 116, 118, 120 and 122, the transistors 130 through 144 (even numbers only) may constitute field effect transistors or any other suitable type of transistor. When field effect transistors are used, the transistors 130, 134, 138 and 142 may constitute N-channel field effect transistors and the transistors 132, 136, 140 and 144 may constitute P-channel effect transistors.

The sources of the N-channel transistors 116, 130 and 138 are connected to an output line 150 and the sources of the P-channel transistors 122, 136, and 144 are connected to an output line 152. A connection is made from the source of the P-channel field effect transistor 118 and the N-channel field effect transistor 120 to an interpolation line 154. The drains of the transistors 116 and 118 are common with the sources of the transistors 132 and 134. Similarly, the drains of the transistors 120 and 122 and the sources of the transistors 140 and 142 have a common terminal.

Connections are made from the drains of the transistors 130 and 132 to an output member 160, from the drains of the transistors 134 and 136 to an output member 162, from the drains of the transistors 138 and 140 to an output member 164 and from the drains of the transistors 142 and 144 to an output member 166. The output members are connected through a line 168 to a voltage source 170. The output members 160, 162, 164 and 166 may constitute transistors which provide a large and substantially constant current when conductive. For example, the members 160, 162, 164 and 166 may constitute C-Mos transistors.

The N-channel field effect transistors are non-conductive when a signal having a relatively low voltage and representing a digital value of "0" are introduced to the bases of the transistors. The N-channel field effect transistors such as the transistor 116 become conductive when a positive voltage representing a digital value of "1" is introduced to the bases of the transistors. In contrast, the P-channel field effect transistors such as the transistor 118 are non-conductive when a positive voltage is introduced to the base of the transistor in representation of a digital value of "1". The P-channel field effect transistors become conductive when a negative voltage representing a digital value of "0" is introduced to the bases of the transistors.

The circuit shown in Figure 3 and described above operates in a manner similar to the circuit shown in Figure 1. This may be seen from the fact that each pair of transistors corresponds to one of the switches shown in Figure 1. For example, a state of conduction in the transistor 116 in Figure 3 corresponds to the disposition of the movable arm of the switch 24 against the right stationary contact of the switch in Figure 1. Similarly, a state of conductivity in the transistor 118 in Figure 3 corresponds to an engagement between the movable arm and the left stationary contact of the switch 24 in Figure 1.

The operation of the circuit of Figure 3 may be seen from specific examples. For example, for an analog value of "1" represented by a digital "1" " on the line 112 and a digital "0" on the line 114, the transistors 116 and 120 become conductive and the transistors 132, 136, 140 and 144 are conductive. This causes current to flow through a circuit including the voltage source 170, the output member 160, the transistor 132 and the transistor 116 to the output line 150 to indicate an analog value of "1". At the same time, current flows through a circuit including the voltage source 170, the output member 164, the transistor 140, the transistor 120 and the interpolation line 154. The currents through the output members 162 and 166 are introduced to the line 152. Since only the current in the line 150 is effective in indicating the analog value represented by the digital signals, an analog value of "1" " is indicated by the current on the line 150.

An amplifier 172 is connected to the line 150 to receive the current through the line and to provide a proper load to the matrix arrangement shown in Figure 3. The amplifier 172 converts the current in the line 150 to a voltage proportional to this current. Amplifiers corresponding to the amplifier 172 are well known in the art. Similarly, an amplifier 176 is connected to the line 152 to present an appropriate load to the line 152.

The transistors 130, 134, 138 and 142 become conductive and the transistors 118 and 122 become conductive for an analog value of "2". When this occurs, the output member 160 passes a signal to the line 150 through the transistor 130 and the output member 164 passes current to the line 150 through the transistor 138. The transistor 162 passes current to the interpolation line 154 through a circuit including the voltage source 170, the output member 162, the transistor 134, the transistor 118 and the interpolation line. The output member 166 passes current to the output line 152 through a circuit including the transistor 142 and the transistor 122. In this way, the output line 150 receives a current from two of the output members, corresponding to the analog value of "2".

Figure 7 indicates an arrangement in which only one particular type of control transistor is used in circuitry corresponding to Figure 3 rather than the two different types of transistors actually shown in Figure 3. In the embodiment shown in Figure 7, each pair of transistors such as the transistors 116 and 118 or the transistors 120 and 122 may be provided by N-channel field effect transistors such as transistors 180 and 182. The base of the transistor 180 is directly connected to an input line such as the line 112. The input line 112 is also connected to the input terminal of an amplifier 184 having its output terminal connected to an inverter 186. A connection is made from the output of the inverter 186 to the base of the transistor 182. The amplifier 184 and the inserter 186 may be an amplifier-inverter and may be disposed in a single package. This is also true of all of the amplifiers and inverters described subsequently.

In the arrangement shown in Figure 7, the transistor 180 becomes conductive in a manner similar to that described above for the transistor 116 when a signal representing a digital value of "1" " is provided on the line 112. At such a time, the transistor 182 remains non-conductive because the digital value of "1" on the line 112 is inverted by the amplifier 184 and the inverter 186 to a digital value of "0". When a digital value of "0" is produced on the line 112, the transistor 180 becomes non-conductive in a manner similar to that described above for the transistor 116 in Figure 3. At the same time, the digital value of "0" is inverted by the amplifier 184 and the inverter 186 so that a signal representing a digital value of "1" " is introduced to the base of the transistor 182 to cause the transistor to become conductive.

Figure 4 provides an arrangement for converting a considerable number of bits of digital information to a corresponding analog signal in a relatively simple manner. In the embodiment shown in Figure 4, output members corresponding to the output members 60 through 74 (even numbers only) in Figure 1 or the output members 160, 162, 164 and 166 in Figure 3 are illustrated on a block basis at 200. The output members are connected in Figure 4 to a block 202 corresponding to the repetitive array shown in Figure 1 or the repetitive array shown in Figure 3. This block may receive siangls representing the binary digits of greatest significance. By way of illustration, these signals are introduced to input lines indicated at 204 in Figure 4. Six (6) input lines are illustrated in Figure 4. These input lines correspond to the input lines 12, 14 and 16 in Figure 1 or the lines 112 and 114 in Figure 14.

An output line 206 extends from the recursive array 202 in Figure 4. The output line 206 corresponds to the output line 82 in Figure 1 or the output line 150 in Figure 3. An interpolation line 208 also extends from the recursive array 202 in Figure 4. The interpolation line 208 corresponds to the line 84 in Figure 1 or the line 154 in Figure 3. The interpolation line 208 in Figure 4 is connected to a block 210 corresponding to the block 200 in Figure 4. The block 210 includes a plurality of output members such as is provided for the block 200. The output members are in turn connected to a repetitive array 212 corresponding to the repetitive array 202 in Figure 4. The repetitive array 212 receives signals of decreased digital significance on lines 211 relative to the signals introduced on the lines 204.

An output line 214 extends from the repetitive array 212. The output line 214 corresponds to the output line 206 from the repetitive array 202. The output lines 206 and 214 are connected to an amplifier 216 corresponding to the amplifier 172 in Figure 3. The output voltage from the amplifier 216 indicates the analog value of the digital signals introduced through the lines 204 to the repetitive array 202 and the corresponding digital signals introduced to the repetitive array 212 through the line 211.

An interpolation line 220 may extend from the repetitive array 212. The interpolation line 220 may correspond to the interpolation line 208 extending from the repetitive array 202. The interpolation line 220 may be connected to an additional block (not shown) corresponding to the blocks 200 and 210. In this way, the chain arrangement shown in Figure 4 may be extended through any number of successive sequences that the user may desire. As will be appreciated, each extension of the chain increases the accuracy in which the digital information is converted to an analog voltage.

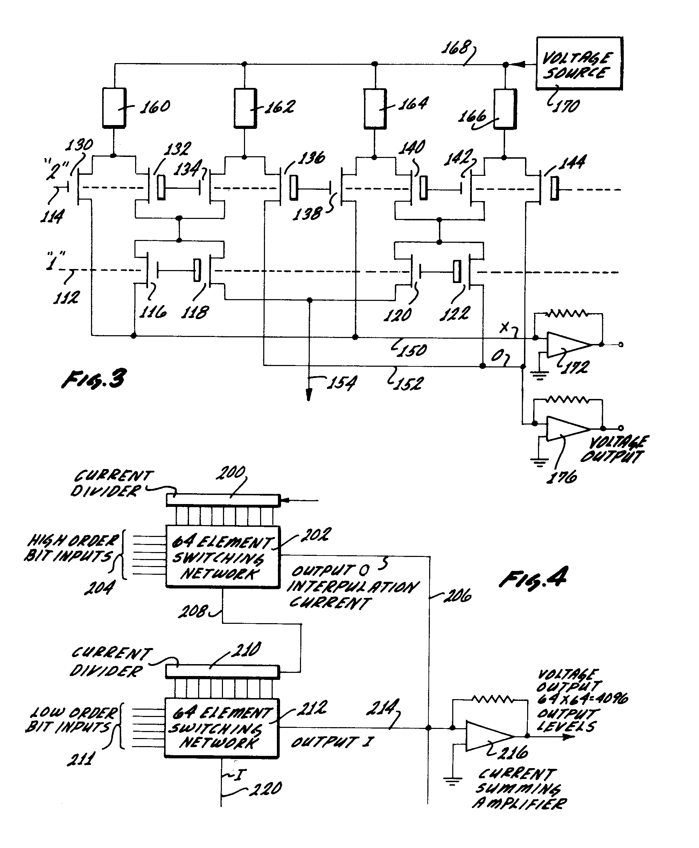

Figure 5 illustrates a circuit for insuring that the output members, such as the transistors 160, 162, 164 and 166 provide a current of a particular magnitude. The transistors 160, 162, 164 and 166 are shown in Figure 5 as having their emitters connected to the line 168 in a manner similar to that shown in Figure 3 and described above. A transistor 250 is also shown as having a similar connection. The transistor 250 may constitute the (n-1)th transistor when there are (n-1) transistors in an arrangement corresponding to the block 202 in Figure 4. The transistors 160, 162, 164, 166 and 250 are shown in Figure 4 as constituting pnp transistors.

The bases of the transistors 160, 162, 164, 166 and 250 and the base of a reference transistor 254 in Figure 5 are connected to the emitter of a transistor 252. The transistors 252 and 254 may also be pnp transistors having characteristics corresponding to the transistors 160, 162, 164 and 166. The base of the transistor 252 is common with the collector of the transistor 254 and with a line 256 providing a reference current. The collector of the transistor 252 may be connected to a reference potential such as ground. Connections are made from the collectors of the transistors 160, 162, 164, 166, 250 and 254 to the repetitive array 202 in Figure 4.

A reference current is drum from the line 168 through the transistor 254 to the line 256. This causes the base of the transistor 252 to receive a potential for making the transistor conductive. The flow of current through the transistor 252 establishes a potential on the transistor 254 for maintaining the flow of current through the transistor 254.

As the current through the transistor 254 increases, the potential on the collector of the transistor 254 decreases toward the ground potential on the collector of the transistor 252. This causes the current through the transistor 252 to increase and causes the transistor 252 to inject additional current into the base of the transistor 254. This action continues until virtually all of the reference current is conducted by the transistor 254.

The transistors 160, 162, 164, 166 and 250 "mirror" the current through the transistor 254 since they are essentially connected in parallel with the transistor 254. This causes the currents through the transistors 160, 162, 164, 166 and 250 to be substantially equal. In this way, the current on the output line 150 in Figure 3 provides an accurate analog indication of the digital value being converted, especially when referenced to the current flowing through the transistor 254.

Figure 6 illustrates another embodiment of apparatus for providing controlled currents to output members. In this sense, Figure 6 corresponds to Figure 5. However, the output members in Figure 6 are metal-oxide-semiconductor (MOS) field effect transistors. One of these transistors is illustrated at 280 in Figure 6.

The converters shown in Figures 1, 3, 4, 5 and 6 and described above have other advantages in addition those described above. For example, the repetitive array is constructed to receive directly the digital signals on the input lines such as the lines 12, 14 and 16 and to operate on such signals to provide, on the output line such as the output line 82, a current having an amplitude directly related to the analog value represented by the digital signals. In this way, the converter has a simple and straightforward construction and is still able to provide an accurate analog indication of a digital value.

By providing an arrangement in which all of the output members such as transistors are conductive and switching progressive output members to an output line such as the line 150 in Figure 3 as the digital value progressively increases, the monotonic operation of the converter shown in Figures 1, 3, 4, 5 and 6 is assured. Furthermore, when the output members such as transistors are made with precision and when a considerable number of transistors are responsive to the operation of the matrix arrangements shown in Figures 1 and 3, the converters operate to provide minimal differential and integral non-linearities. The monotonic operation of the converter is further assured because all of the output members remain continuously conductive, whether they are connected to either one of the output lines such as the lines 150 and 152 in Figure 3.

Since the output members such as transistors previously connected to the output line such as the line 150 continue to remain connected to this line and additional output transistors become connected to the output line 150 as the digital value progressively increases, no discontinuities are produced as the number being converted changes from a decimal value such as "511 " to a decimal value such as "512" or from a decimal value such as "1023" to a decimal value such as "1024". This further assures that the converters of Figures 1, 3, 4, 5 and 6 are monotonic.

The converters shown in Figures 1, 3, 4, 5 and 6 and described above may be incorporated on an integrated circuit chip generally indicated at 300 in Figure 8. This is particularly true in view of the simple and straightforward construction of the particular matrix arrangement such as the matrix arrangement 202 in Figure 4. However, the amplifier arrangement, such as the amplifiers 172 and 176 in Figure 2, probably will not be incorporated as part of the integrated circuitry on the chip.

Such incorporation of the converter on the chip may be provided by large-scale integration (LSI) or very large scale integration (VLSI) techniques. In this way, the apparatus may be self-contained. Furthermore, since all of the transistors are formed simultaneously and the chip is quite small the transistors have substantially identical characteristics. This is particularly true since the chip has a surface area less than approximately one tenth inch (1/10") square. The simultaneous formation of the output devices on such a small chip tends to assure that the current on the output line, such as the output line 82 in Figure 1, indicates accurately in analog form the digital information represented by the signals on the input lines such as the lines 12, 14 and 16 in Figure 1.

Actually, a plurality of modules may be provided on a single chip generally indicated at 302 in Figure 9. The modules are indicated schematically at 304, 306, 308 and 310 in Figure 9. Each of the modules may be constructed in a manner similar to that shown in Figure 1 or Figure 3. In this way, an increased number of digits can be provided by combining the modules 304 and 306 to provide a single output from the two modules. For example, the interpolation line from the module 304 may be connected to the module 306 so that the module 304 corresponds to the current divider 200 and the switching network 202 in Figure 4 and the module 306 corresponds to the current divider 210 and the switching network 212 in Figure 4. Similar connections may be made to the modules 308 and 310 to increase the number of digits being converted to an analog value.

The provision of a plurality of modules on a single chip also offers other advantages. For example, if tests indicate that the module 308 is defective the module 304, 306 and 310 can still be used in combination to provide an enhanced digital significance. This module can be sold to a customer who is interested only in an accuracy represented by three (3) modules rather than four (4). In this way, a defective module does not necessarily mean a destruction of the chip but indicates only that the chip may have to be downgraded in the accuracy of its conversion of digital information to analog information.

In order to increase the accuracy of the output current on the output line 150, the different transistors may be disposed in a spaced relationship such as shown in Figure 10. For example, the transistors 116, 118, 120 and 122 in Figure 3 may be considered to indicate the analog value of the binary signal on the input line 112. These transistors may be accordingly disposed at spaced positions on the chip. Similarly, the transistors 130 through 144 (even numbers only) may be considered to indicate in analog form the values of the signal on the line 114. These transistors may accordingly be disposed in spaced relationship on the chip relative to each other and to the transistors 116, 118, 120 and 122.

By disposing in a spaced relationship the transistors representing each binary digit, any deviations in the characteristics of the chip at isolated positions on the chip can be averaged in the transistors of each group so that the accuracy of the output current on the line 150 is enhanced. It will be appreciated that the arrangement shown in Figure 10 is only by way of example and that the disposition of the transistors may be provided in any suitably spaced relationship to obtain the desired averaging effect.

Additional transistors generally indicated at 320 in Figure 11 may also be provided on the chip 300 in Figure 8 or in the modules on the chip 302 in Figure 9. These additional transistors have characteristics substantially identical to the characteristics of the output transistors in Figure 3. The additional transistors 320 operate in conjunction with the system shown in Figure 11 to regulate the current through the output transistors shown in Figure 3 such as the transistors 160, 162, 164 and 166.

In the system shown in Figure 11, a current flows through the additional transistors 320 from a voltage source 322 corresponding to the voltage source 170 in Figure 3. The current flowing through the additional transistors 320 is compared in a comparator 324 with a reference current on a line 326. The output signal from the comparator 324 constitutes an error representing any difference in the comparison. The error signal is introduced to the voltage source 322 to vary the voltage from the source so that the current through the additional transistors 320 becomes equal to the reference current. The adjusted voltage from the source 322 is introduced to the collectors of the output transistors 160 through 166 (even numbers) of Figure 3 through a line 328 to produce corresponding adjustments in the currents through the output transistors. In this way, the current on the output line 150 in Figure 3 is adjusted so that it provides a true analog value of the digital representation.

Any number of transistors may be used as the additional transistors 320 and may be disposed on the chip 300 in Figure 8 or in the modules 304, 306, 308 and 310 on the chip 302 in Figure 9. The additional transistors may be spaced throughout the chip 300 in Figure 8 or throughout each of the modules on the chip 302 in Figure 9 in a manner similar to that described for the transistors in Figure 3. As will be appreciated a group of additional transistors 320 may be individually associated with each of the modules 304, 306, 308 and 310. In this way, the currents through the additional transistors 320 are averaged to compensate for deviations in the characteristics of the output transistors in Figure 3 as a result of localized deviations in the characteristics of the material on the chip 300 in Figure 8 or the chip 302 in Figure 9.

The converters shown in Figures 1, 3, 4, 5 and 6 and described above convert digital signals to an analog representation in Figure 12 to provide a conversion of analog information to a plurality of digital signals representing the analog information.

In the embodiment shown in Figure 12, an analog signal is provided on a line 340. This analog signal is to be converted to digital form. This analog signal is compared in a comparator 342 with the analog signal on a line 344 which corresponds to the output line 150 in the converter shown in Figure 3. The results of the comparison from the comparator 342 are introduced through a line 346 to a data processor such as a microprocessor 348. The microprocessor 348 processes the information represented by the signal on the line 346 and introduces signals to the input terminals of a digital-to-analog converter 350 corresponding to the converter shown in Figure 1 or in Figure 3. The signals introduced to the digital-to-analog converter 350 cause the converter to provide an analog signal on the line 344 corresponding in characteristics to the analog signal on the line 340. When the analog signal on the line 344 corresponds in characteristics to the analog signal on the line 340, the output signals on lines 358 from the microprocessor constitute the digital signals which are introduced to the analog converter of Figures 1, 3 or 4 to obtain a conversion into a corresponding analog signal.

The apparatus described above has certain important advantages in addition to the advantage described above. It provides a conversion between digital and analog values at a fast rate because the conversion results from the connection to an output line of output members each constituting a simple current source. The conversion is also accurate because the control of the output signal is obtained by the operation of a plurality of control switches which are connected in a repetitive array to be instantaneously responsive to the digital signals introduced to the array. The conversion is accurate and reliable, particularly when the converter is disposed on an integrated circuit chip. This results from the fact that the chip is quite small and the chip has substantially uniform characteristics throughout its surface area. For example, the chip may have a surface area less than 2.5 mm (0.1 inch) square. Furthermore, the accuracy of the conversion can be enhanced by disposing the control switches in each group in a spaced relationship throughout the surface area of the chip.

The converter of this invention also has other advantages of some importance. For example, the converter is monotonic. This results from the fact that the conversion to analog form of digital signals of progressively increasing value is obtained by connecting an increased number of output members to a particular output line, while maintaining the connection to the particular output line of output members previously connected to the line. Furthermore, by connecting output members to the particular output line to convert digital information to an analog form, errors resulting from differential and integral non-linearities are minimized. This is particularly true when the output members are precision transistors, particularly transistors providing a precision flow of current as in Figure 5, and when there are a considerable number of output members in the converters. It is also particularly true because the output members are conductive at all times.

The converters of this invention also have other advantages of some importance. For example, they introduce digital signals directly to a particular repetitive array without requiring that the digital signals be modified by decoders as in the prior art. Furthermore, the repetitive array is relatively simple and straightforward and operates to introduce current to an output line with a magnitude directly related to the analog value represented by the digital signals. This particular repetitive array is further advantageous because the paired relationship of the switches in the repetitive array causes substantially the same number of switches in the repetitive array to be closed regardless of the digital value to be converted. Since substantially the same number of switches remains closed, the repetitive array has a balanced operation which contributes to the monoticity and integral and differential linearity of the converters of this invention. The balanced operation is enhanced because all of the output members are continously conductive whether they be connected to either one of the output lines such as the line 150 or the line 152 in Figure 3.

There are other important advantages to the converter of this invention. For example, the converter of this invention is quite small. This is particularly true when the converters of this invention are compared with the converters which attempt to provide a comparable accuracy in the prior art. The converters of this invention are also quite inexpensive. This results in part from the production of the converter on a single chip.

The converter of this invention also offers the advantage of providing high output currents. This results from the fact that the amount of power delivered at the output line, such as the line 82 in Figure 1, can be adjusted by varying the number and size of the control switches in each stage in the matrix relationship. For example, the output current can be doubled by doubling the number of switches in each stage. As a result of its ability to supply a large current, the converter of this invention can be considered to provide a current amplification at the same time that it provides a conversion. This is important in such applications as the conversion of aural information such as sound. The invention accordingly has a particular utilitity in the recently developed techniques of digital recording and reproduction of sound.

The apparatus of this invention is easily adaptable to provide for an addition of digits to increase its accuracy. This results in part from the modular construction of the apparatus such as shown in Figure 4 and the provision of the repetitive array. The apparatus also maintains its accuracy as it ages. This is particularly true when the apparatus is disposed on a chip such as shown in Figure 8 or Figure 9. The apparatus maintains its accuracy as it ages because the chip is essentially homogeneous in construction. As a result, all of the switches on the chip age in substantially identical relationships. The disposition of the different switches in spaced relationship on the chip also facilitates an aging in which the accuracy is maintained.

The converter is also substantially free of the effects of temperature for substantially the same reasons as discussed above with respect to aging. This is particularly true when the current on the output terminal is regulated as shown in Figure 11 and as discussed above. Such avoidance in the chip of the effects of temperature variations also results from the fact that the distrubution of the switches in each group throughout the surface area of the chip prevents the temperature of the chip from becoming excessive at any localized areas.

The converter of this invention also has another advantage of some significance. In the particular repetitive array shown in Figures 1 and 3, the width of the switches for each digit can be varied inversely to its numerical significance. For example, the switches 24 and 26 in Figure 1 can be made wider than the switches 30, 32, 34 and 36. This increases the accuracy in the conversion between digital and analog values.

Although this invention has been disclosed and illustrated with reference to particular embodiments, the principles involved are susceptible for use in numerous other embodiments which will be apparent to persons skilled in the art. The invention is, therefore, to be limited only as indicated by the scope of the appended claims.

## Claims

1. An apparatus for providing a conversion between a binary coded input word defined by a plurality of bits and an analog value, comprising means (12, 14, 16, 112, 114) for providing a plurality of binary coded input signals each corresponding to a particular bit in the binary coded input word, a plurality of switches (24, 54; 116-144) , a plurality of current means (60-74, 160-166) each operative to pass a current, a line (82, 150) and means for connecting the switches (24-54, 116-144), the current means (60-74, 160-166) and the line to provide in response to increases in the binary coded input word progressive increases in the number of said current means passing currents to the line (82, 150) while maintaining the passage of currents to the line from the current means previously passing currents to said line and characterized in that
each of said switches (25-54, 116-144) is responsive to only a particular one of the binary coded input signals, the number of switches responsive to the same particular binary coded input signal, depending on the binary significance of such signal, all switches associated with a signal of particular significance being connected in a subset so that all switches in a subset are synchronously operative in response to the related binary input signal the switches further being connected in an array having a repetitive pattern, the basic element of this repetitive pattern being formed by one switch from a subset of a given binary significance and two switches from a subset of the next binary significance, the one switch from the subset of the given binary significance receiving a current from one or the other of the two switches depending on the related binary input signal, the one switch being connected to the line either directly or via switches of subsets of previous binary significance, and the two switches of the basic element being connected to the current means either directly or via switches of subsets of next binary significance.

2. The apparatus as claimed in claim 1, further characterized by a second line (80, 152), and means for connecting the switches (24-54, 116-144), the current means (60-74, 160-166) and the second line to provide in response to decreases in the binary coded input word, progressive increases in the number of current means passing current to the second line while maintaining the passage of currents to said second line from the current means previously passing currents to said second line.

3. The apparatus as claimed in claims 1 or 2, further characterized in that the switches (116-144) are provided by paired solid state switches (116,118; 120-122; 130,132; 134,136; 138,140; 142,144) to provide for the operation of only one solid state switch in each pair at each instant and to provide for the selection of the solid state switch in each pair for operation in accordance with the binary coded input signal introduced to such pair of solid state switches and wherein the pattern of operation of the solid state switches in the pairs controls the passage of current from the current means (60-74, 160-166) to the line (82,150).

4. The apparatus as claimed in any of the preceding claims, further characterized in that each of the switches (25-54, 118-144) is operative in the repetitive pattern to provide for the passage of a current through only an individual one of the current means (60-74, 160-166) in the plurality, such individual one of the current means in the plurality being dependent at each instant upon the binary coded input word.

5. The apparatus as claimed in any of the preceding claims, further characterized in that the number of switches (25-54, 118-144) in each subset is directly proportional to the binary value of the switches in the subset.

6. The apparatus as claimed in any of the preceding claims, further characterized in that the same magnitude of current flows through each of the switches (25-54, 118-144) in each subset regardless of the value of the binary coded input word.

7. The apparatus as claimed in any of the preceding claims, further characterized by a third line (84, 154, 208) connected at each instant to the repetitive pattern and to the next one of the current means (60-74, 160-166) in the plurality to be connected to the first line (82, 150) with progressive increases in the binary coded input word and to the next one of the current means to be connected to the second line (80, 152) with progressive decreases in the binary coded input word.

## Patentansprüche

1. Vorrichtung zur Erzeugung einer Umwandlung zwischen einem binär codierten Eingangswort, welches durch eine Mehrzahl von Binärzeichen definiert ist, und einem analogen Wert, umfassend Einrichtungen (12, 14, 16, 112, 114) zur Bereitstellung einer Mehrzahl von binär codierten Eingangssignalen, von denen jedes einem bestimmten Binärzeichen in dem binär codierten Eingangswort entspricht, sowie eine Mehrzahl von Schaltern (24, 54; 116-144), eine Mehrzahl von Stromeinrichtungen (60-74, 160-166), von denen jede funktionsfähig ist einen Strom zu übermitteln, eine Leitung (82, 150) und Einrichtung zur Verbindung der Schalter (24-54, 116-144), wobei die Stromeinrichtungen (60-74, 160-166) und die Leitung als Reaktion auf Zunahmen des binär codierten Eingangswortes für progressive zunahmen in der Stromübermittlung durch die Anzahl der Stromeinrichtungen zu der Leitung (82, 150) sorgen, wobei die Stromübermittlung zu der Leitung von den Stromeinrichtungen, die vorher Strom zu der genannten Leitung übermittelt haben, aufrecht erhalten wird, und dadurch gekennzeichnet, dass :
jeder der genannten Schalter (25-54, 116-144) nur auf ein bestimmtes der binär codierten Eingangssignale anspricht, wobei die Anzahl der Schalter, die auf das gleiche bestimmte binär codierte Eingangssignal ansprechen, von der binären Signifikanz dieses Signals abhängig ist, wobei alle Schalter, die einem Signal mit bestimmter Signifikanz zugeordnet sind, in einem Teilsatz verbunden sind, so daß alle Schalter in einem Teilsatz gleichzeitig funktionsfähig sind, als Reaktion auf das zugeordnete binäre Eingangssignal, wobei die Schalter ferner in einem Array mit einer sich wiederholenden Form verbunden sind, wobei das Grundelement dieser sich wiederholenden Form von einem Schalter eines Teilsatzes mit gegebener binärer Signifikanz und von zwei Schaltern eines Teilsatzes der nächsten binären Signifikanz gebildet wird, wobei der eine Schalter, von dem Teilsatz mit der gegebenen binären Signifikanz, Strom von einem oder dem anderen der zwei Schalter empfängt, abhängig von dem zugehörigen binären Eingangssignal, wobei der eine Schalter entweder direkt mit der Leitung verbunden ist, oder über Schalter von Teilsätzen vorheriger binärer Signifikanzen, und wobei die zwei Schalter des Grundelements mit der Stromeinrichtung entweder direkt verbunden sind, oder über Schalter von Teilsätzen der nächsten binären Signifikanz.

2. Vorrichtung nach Anspruch 1, ferner gekennzeichnet durch eine zweite Leitung (80, 152) und eine Einrichtung zur Verbindung der Schalter (24-54, 116-144), wobei die Stromeinrichtungen (60-74, 160-166) und die zweite Leitung als Reaktion auf Abnahmen des binär codierten Eingangswortes für progressive Zunahmen der Anzahl der Stromeinrichtungen sorgen, die der zweiten Leitung Strom übermitteln, wobei die Stromübermittlung von den Stromeinrichtungen, die vorher der zweiten Leitung Strom übermittelt haben, zu der zweiten Leitung aufrecht erhalten wird.

3. Vorrichtung nach Anspruch 1 oder 2, ferner dadurch gekennzeichnet, daß die Schalter (116-144) durch paarweise Festkörperschalter (116,118; 120-122; 130,132; 134,136; 138,140; 142,144) bereitgestellt sind, um zu jedem Moment für die Funktion von nur einem Festkörperschalter in jedem Paar zu sorgen, und um für die Auswahl des Festkörperschalters in jedem Paar zu sorgen, zur Funktion gemäß des binär codierten Eingangssignals, welches diesem Festkörperschalterpaar zugeführt worden ist, und dadurch gekennzeichnet, daß die Ausführung der Funktion der Festkörperschalter in den Paaren, die Stromübermittlung von den Stromeinrichtungen (60-74, 160-166) zu der Leitung (82, 150) regelt.

4. Vorrichtung gemäß einem der vorstehenden Ansprüche, ferner dadurch gekennzeichnet, daß jeder der Schalter (25-54, 118-144) in dem Wiederholungs-Array so funktionsfähig ist, daß er für die Stromübermittlung durch nur eine einzelne der Stromeinrichtungen (60-74, 160-166) aus der Mehrzahl der Stromeinrichtungen sorgt, wobei diese eine einzelne Stromeinrichtung aus der Mehrzahl der Stromeinrichtungen zu jedem Moment von dem binär codierten Eingangswort abhängig ist.

5. Vorrichtung gemäß einem der vorstehenden Ansprüche, ferner dadurch gekennzeichnet, daß die Anzahl der Schalter (25-54, 118-144) in jedem Teilsatz direkt proportional zu den Binärwerten der Schalter in dem Teilsatz ist.

6. Vorrichtung gemäß einem der vorstehenden Ansprüche, ferner dadurch gekennzeichnet, daß in jedem Teilsatz die gleiche Strommenge durch jeden der Schalter (25-54, 118-144) fließt, unabhängig von dem Wert des binär codierten Eingangswortes.

7. Vorrichtung gemäß einem der vorstehenden Ansprüche, ferner gekennzeichnet durch eine dritte Leitung (84, 154, 208), die zu jedem Moment mit dem Wiederholungs-Array verbunden ist, sowie mit der nächsten der Stromeinrichtungen (60-74, 160-166) der Mehrzahl von Stromeinrichtungen, um so bei progressiven Zunahmen des binär codierten Eingangswortes mit der ersten Leitung (82, 150) verbunden zu sein, und mit der nächsten der Stromeinrichtungen, um so bei progressiven Abnahmen des binär codierten Eingangswortes mit der zweiten Leitung (80, 152) verbunden zu sein.

## Revendications

1. Appareil destiné à réaliser la conversion entre un mot d'entrée codé binaire défini par une pluralité de bits et une valeur analogique, comprenant un moyen (12, 14, 16, 112, 114) servant à produire une pluralité de signaux d'entrée codés binaires correspondant chacun à un bit particulier du mot d'entrée codé binaire, une pluralité de commutateurs (24, 54 ; 116 à 144), une pluralité de moyens de courant (60 à 74, 160 à 166) ayant chacun pour fonction de laisser passer un courant, une ligne (82, 150), et un moyen servant à connecter les commutateurs (24 à 54, 116 à 144), les moyens de courant (60 à 74, 160 à 166) et la ligne afin de produire, en réponse à des augmentations du mot d'entrée codé binaire, des augmentations progressives du nombre desdits moyens de courant laissant passer des courants à destination de la ligne (82, 150) tout en maintenant le passage de courants à la ligne en provenant des moyens de courant qui laissaient précédemment passer des courants à ladite ligne, et caractérisé en ce que :
chacun desdits commutateurs (25 à 54, 116 à 144) ne répond qu'à un seulement, particulier, des signaux d'entrée codés binaires, le nombre de commutateurs qui répondent au même signal d'entrée codé binaire particulier dépendant du poids binaire de ce signal, tous les commutateurs associés à un signal d'un poids particulier étant connectés en un sous-ensemble de façon que tous les commutateurs d'un sous-ensemble agissent en synchronisme en réponse au signal d'entrée binaire associé, les commutateurs étant en outre connectés en un groupe qui présente une configuration répétitive, l'élément de base de cette configuration répétitive étant formé par un premier commutateur d'un sous-ensemble d'un poids binaire donné et deux commutateurs d'un sous-ensemble du poids binaire suivant, le premier commutateur du sous-ensemble du poids binaire donné recevant du courant de l'un ou l'autre des deux commutateurs en fonction du signal d'entrée binaire associé, le premier commutateur étant connecté à la ligne soit directement, soit par l'intermédiaire de commutateurs de sous-ensembles de poids binaire précédent, et les deux commutateurs de l'élément de base étant connectés aux moyens de courant soit directement, soit par l'intermédiaire de commutateurs de sous-ensembles de poids binaire suivant.

2. Appareil selon la revendication 1, caractérisé en outre par une deuxième ligne (80, 152), et un moyen servant à connecter les commutateurs (24 à 54, 116 à 144), les moyens de courant (60 à 74, 160 à 166) et la deuxième ligne de manière à produire, en réponse à des diminutions du mot d'entrée codé binaire, des augmentations progressives du nombre de moyens de courant laissant passer un courant à destination de la deuxième ligne, tout en maintenant le passage de courants à ladite deuxième ligne en provenance des moyens de courant qui laissaient précédemment passer des courants à ladite deuxième ligne.

3. Appareil selon la revendication 1 ou 2, caractérisé en outre en ce que les commutateurs (116 à 144) sont produits par des commutateurs du type état solide appariés (116, 118; 120-122; 130, 132; 134, 136; 138, 140; 142, 144) de façon à ne permettre le fonctionnement que d'un seul commutateur du type état solide dans chaque paire à chaque instant et de permettre la sélection du commutateur du type état solide de chaque paire en vue de son fonctionnement en relation avec le signal d'entrée codé binaire introduit dans cette paire de commutateurs du type état solide, et où la configuration de fonctionnement des commutateurs du type état solide des paires commande le passage du courant des moyens de courant (60 à 74, 160 à 166) à la ligne (82, 150).

4. Appareil selon l'une quelconque des revendications précédentes, caractérisé en outre en ce que chacun des commutateurs (25 à 54, 118 à 144) a pour fonction, dans la configuration répétitive, de ne permettre le passage d'un courant que par l'un, particulier, des moyens de courant (60 à 74, 160 à 166) de la pluralité, ce moyen de courant particulier de la pluralité dépendant à chaque instant du mot d'entre codé binaire.

5. Appareil selon l'une quelconque des revendications précédentes, caractérise, en outre en ce que le nombre de commutateurs (25 à 54, 118 à 144) de chaque sous-ensemble est proportionnel à la valeur binaire des commutateurs du sous-ensemble.

6. Appareil selon l'une quelconque des revendications précédentes, caractérisé en outre en ce qu'une même intensité de courant circule dans chacun des commutateurs (25 à 54, 118 à 144) de chaque sous-ensemble indépendamment de la valeur du mot d'entrée codé binaire.

7. Appareil selon l'une quelconque des revendications précédentes, caractérisé en outre par une troisième ligne (84, 154, 208) connectée à chaque instant à la configuration répétitive et au moyen de courant suivant parmi les moyens de courant (60 à 74, 160 à 166) de la pluralité devant se connecter à la première ligne (82, 150) avec les augmentations progressives du mot d'entrée codé binaire, ainsi qu'au moyen de courant suivant parmi les moyens de courant devant se connecter à la deuxième ligne (80, 152) avec les diminutions progressives du mot d'entrée codé binaire.
